# EUROPÄISCHE PATENTANMELDUNG

(11) **EP 2 284 933 A1**
(43) Veröffentlichungstag der Anmeldung: **16.02.2011**
(21) Anmeldenummer: 09009472.3
(22) Anmeldetag: 22.07.2009
(51) Int. Cl.: H01M 4/04, H01M 4/62, H01M 4/66

(54) **Verfahren zur Herstellung von dehnbaren Elektroden**

(71) Anmelder: Bayer MaterialScience AG, 51368 Leverkusen (DE)
(72) Erfinder: Vogel, Stephanie, Dr., 40764 Langenfeld (DE); Wagner, Joachim, Dr., 51061 Köln (DE); Fußangel, Christel, 41462 Neuss (DE)

(57) **Zusammenfassung**

Die vorliegende Erfindung betrifft ein Verfahren zur Herstellung von dehnbaren Elektroden. Hierbei werden elektrisch leitfähige Kohlenstoffteilchen in eine ein Elastomer umfassende Oberflächenschicht eingebracht. Diese Kohlenstoffteilchen können insbesondere Kohlenstoff-Nanoröhren sein. Im Verfahren wirkt eine Zubereitung von nicht aggregierten Kohlenstoffteilchen mit einem mittleren Teilchendurchmesser von ≥ 0,3 nm bis ≤ 3000 nm in einem Lösungsmittel auf eine ein Elastomer umfassende Oberflächenschicht ein. Das Lösungsmittel ist in der Lage, das Aufquellen einer ein Elastomer umfassenden Oberflächenschicht zu bewirken. Die Einwirkdauer ist so bemessen, dass sie nicht ausreicht, um das Elastomer in Lösung zu überführen. Optional wird noch eine weitere elektrisch leitfähige Schicht aufgetragen. Ebenfalls betrifft die Erfindung eine so erhältliche dehnbare Elektrode sowie deren Verwendung.

## Beschreibung

Die vorliegende Erfindung betrifft ein Verfahren zur Herstellung von dehnbaren Elektroden. Hierbei werden elektrisch leitfähige Kohlenstoffteilchen in eine ein Elastomer umfassende Oberflächenschicht eingebracht. Diese Kohlenstoffteilchen können insbesondere Kohlenstoff-Nanoröhren sein. Weiterhin betrifft die Erfindung eine erfindungsgemäß erhältliche dehnbare Elektrode sowie die Verwendung einer solchen Elektrode.

Kohlenstoffnanoröhren (carbon nanotubes, CNTs) sind für ihre außergewöhnlichen Eigenschaften bekannt. So beträgt beispielsweise deren Festigkeit das ungefähr 100-fache des Stahls, deren thermische Leitfähigkeit ist etwa doppelt so groß wie die von Diamant, ihre thermische Stabilität reicht bis hoch zu 2800 °C im Vakuum und deren elektrische Leitfähigkeit kann ein Vielfaches der Leitfähigkeit von Kupfer betragen. Diese strukhubedingten Charakteristika sind auf molekularer Ebene allerdings nur dann zugänglich, wenn es gelingt, Kohlenstoffnanoröhren homogen zu verteilen und einen möglichst großen Kontakt zwischen den Röhren und dem Medium herzustellen, also diese mit dem Medium verträglich und somit stabil dispergierbar zu machen. Hinsichtlich elektrischer Leitfähigkeit ist es weiterhin erforderlich, ein gegebenenfalls homogenes Netzwerk an Röhren auszubilden, in dem sich diese im Idealfall nur an den Enden berühren. Hierbei sollten die Kohlenstoffnanoröhren möglichst vereinzelt, das heißt agglomeratfrei, nicht ausgerichtet und in einer Konzentration vorliegen, bei der sich ein solches Netzwerk gerade eben ausbilden kann, was sich durch den sprunghaften Anstieg der elektrischen Leitfähigkeit in Abhängigkeit von der Konzentration an Kohlenstoffnanoröhren widerspiegelt (Perkolationsgrenze).

Elektrisch leitfähige Materialien, welche bei mechanischer Beanspruchung ihre leitfähigen Eigenschaften nicht oder nur geringfügig verändern, sind für Anwendungen zum Beispiel unter dem Schlagwort "intelligente Bekleidung", flexible Display-Elemente, dehnbare elektrische Schaltungen, Implantate, Prothesen, mikroelektromechanische Systeme (MEMS) und dielektrische Elastomer-Aktuatoren einsetzbar. Die bei solchen Anwendungen wirkenden mechanischen Dehnungen können im Bereich von weniger als 5% bis hin zu über 200% reichen.

Der bislang übliche Ansatz zur Herstellung von dehnbaren Elektroden beschränkte sich auf die Auswahl eines Elastomers, welches den erforderlichen mechanischen Ansprüchen gerecht wird und dessen nachträglicher Behandlung mit elektrisch leitfähigen Materialien. Diese Materialien können zum Beispiel Leitruße oder Metallpulver sein, die eingebettet in einer flüssigen Matrix auf die Elastomeroberfläche gestrichen werden. Nach dem Verdampfen des Lösungsmittels bleibt eine dünne Schicht des leitfähigen Materials auf der Elektrode zurück. Eine Diskussion verschiedener Methoden findet sich in der Veröffentlichung von S. R. Ghaffarian et al. in Journal of Optoelectronics and Advanced Materials 2007, 9, 3585-3591.

Die Probleme, die mit dieser Methode einhergehen, liegen auf der Hand. Die Elektrode kann durch mechanische Beanspruchung abgenutzt werden und sie besitzt grundlegend andere mechanische Dehnbarkeiten als das Trägerelastomer. Letzteres führt dazu, dass die weniger elastische Elektrode bei mechanischer Beanspruchung früher reißt. Solche Risse stellen Leitungsbrüche dar und können in Summe zum Verlust der Funktionsweise einer solchen dehnbaren Zweischicht-Elektrode führen. Durch die Variante, das elektrisch leitfähige Material auf ein vorgedehntes Elastomer aufzubringen, kann man zwar noch einige Prozent an Dehnung der Elektrode um den Bereich der Vordehnung ohne Verlust an Leitfähigkeit gewinnen. Allerdings bewirkt die Beschichtung eines Elastomers mit einem Elektrodenmaterial wie Leitsilber immer den unerwünschten Anstieg des E-Moduls, führt also zu Einbußen in den mechanischen Eigenschaften der dehnbaren Elektrode. Dieses kann je nach Anwendung und Materialien sogar dazu führen, dass die Versteifung des Trägerelastomers bereits vor Erreichen der Perkolationsgrenze des Elektrodenmaterials den Toleranzbereich überschreitet.

In einer neueren Arbeit wird beispielsweise von E. Smela et al. in der Veröffentlichung Advanced Materials 2007, 19, 2629-2633 berichtet, dass dehnbare Elektroden durch Vermischen eines Metallsalzes mit einer strahlenhärtbaren Elastomervorläufer-Verbindung, Aushärten und Reduktion mit einer Reduktionslösung erhalten werden können

Zwei Aspekte müssen für eine erfolgreiche Verarbeitung von Kohlenstoffnanoröhren, wenn man durch ihre Nutzung einen Werkstoff beispielsweise elektrisch leitfähig machen möchte, berücksichtigt werden: das vollständige Aufbrechen und Entbündeln von Kohlenstoffnanoröhren-Agglomeraten und die Unterdrückung der großen Neigung von Kohlenstoffnanoröhren zur Reagglomeration (in ein und demselben Medium während des Alterungsprozesses oder während der Verarbeitung einer solchen Dispersion zum fertigen Werkstoff). Diese Schwierigkeiten bei der Kohlenstoffnanoröhren-Verarbeitung fußen auf den hydrophoben Charakter der Kohlenstoffnanoröhren-Oberfläche und das hohe Aspektverhältnis dieser quasi eindimensionalen Struktur.

Soll nun vermieden werden, dass Kohlenstoffnanoröhren in der Form von Bündeln und/oder Agglomeraten ein energetisches Minimum in ihrer wechselseitigen Anordnung finden, muss ihre Verträglichkeit mit dem sie umgebenden Medium erhöht werden. Hierbei ist allerdings zu beachten, dass eine chemische, kovalente Funktionalisierung von Kohlenstoffnanoröhren ihre Verträglichkeit mit dem Polymer-Medium tatsächlich verbessern kann. Dies äußert sich zum Beispiel in einer erhöhten (thermischen) Langzeitstabilität und dem Ausbleiben von Reagglomeration. Allerdings wird durch diese Oberflächenmodifikation auch das delokalisierte π-Elektronensystem der Röhre unterbrochen und somit die elektrische Leitfähigkeit jeder einzelnen Röhre in Abhängigkeit des Funktionalisierungsgrades erniedrigt.

Die nicht kovalente Funktionalisierung von Kohlenstoffnanoröhren durch beispielsweise Dispergieradditive stellt eine Alternative zur chemischen, kovalenten Modifikation und Verträglichmachung der Röhre mit dem Medium dar. Allerdings muss hierbei beachtet werden, dass dieser Ansatz für jedes neue Medium, egal ob Elastomer-Rohstoff oder -Formulierung, einer neuen Optimierung hinsichtlich der Chemie und der Konzentration des jeweiligen Dispergieradditivs bedarf und niemals eine Universallösung darstellen kann.

Zuletzt gilt es zu beachten, dass jede Verarbeitung von Füllstoffen, so auch von Kohlenstoffnanoröhren, auch Risiken in der Hinsicht birgt, dass möglicherweise eine neue Eigenschaft, beispielsweise die elektrische Leitfähigkeit, erzielt werden kann, gleichzeitig allerdings mehrere andere, zum Beispiel mechanische, Eigenschaften verschlechtert werden können. Dies ist vor allem dann kritisch, wenn Kohlenstoffnanoröhren in ungeschäumte, kompakte und/oder elastische Systeme eingearbeitet werden. Restagglomerate, die während des Dispergierprozesses nicht vollständig aufgebrochen werden konnten, stellen beispielsweise in einem kompakten Formteil eine Sollbruchstelle dar. Mechanische Eigenschaften wie zum Beispiel die Schlagzähigkeit und Bruchfestigkeit können durch solche Agglomerate verschlechtert werden. Mit der Absicht nun, einen kompakten Werkstoff durch den Zusatz von Kohlenstoffnanoröhren elektrisch leitfähig zu machen, müssten nach dem bisherigen Stand der Technik über das gesamte Volumen des Werkstoffes Kohlenstoffnanoröhren homogen verteilt sein, sodass die Perkolationsgrenze überschritten wird und gleichzeitig keine Restagglomerate mehr vorliegen.

Diese Vorgehensweise scheitert sehr oft bereits an den dramatischen Viskositätsanstiegen, welche durch die hierfür erforderlichen Kohlenstoffnanoröhren-Konzentrationen zum Überschreiten der Perkolationsgrenze bedingt sind. Des Weiteren kann die Reagglomeration von homogen dispergierten Kohlenstoffnanoröhren während der Elastomer-Verarbeitung mit dieser Methode nicht ausgeschlossen und ohne Weiteres verhindert werden.

Im Zusammenhang mit der Verarbeitung von Kohlenstoffnanoröhren in (thermoplastischen) Polyurethanen sind zahlreiche Arbeiten literaturbekannt, bei denen das fertige Polymer zuerst vollständig in einem organischen Lösungsmittel aufgelöst wird, anschließend die Nanoröhren-Dispergierung in dieser Polymerlösung erfolgt und die so erhaltene Nanoröhren-Dispersion auf Polyurethan/Lösungsmittelbasis zu einem Film gezogen oder in eine Form gegossen wird. Der letzte Schritt ist bei diesen Verfahren jeweils die langwierige Verdampfung der großen Mengen an Lösungsmittel.

Eine mögliche Alternative stellt der Ansatz dar, nicht die gesamte Polymermatrix, sondern nur eine unmittelbar an die Oberfläche angrenzende Materialschicht mit den Partikeln auszustatten. Wünschenswert wäre ein solches Vorgehen, um die eingangs beschriebenen Nachteile des Lösungsmittelverbrauchs, des Viskositätsanstiegs und die negativen Einflüsse auf die Mechanik der Polymermatrix zu vermeiden.

WO 2008/150867 A2 offenbart ein Verfahren zum Einbetten von Partikeln in ein Substrat. In diesem Verfahren wird auf mindestens einem Teil des Substrats ein Fluid appliziert, welches eine Population von Partikeln mit wenigstens einer charakteristischen Dimension im Bereich von ungefähr 0,1 nm bis ungefähr 1 cm umfasst. Das Applizieren geschieht in einer Weise, dass das Substrat bis zu einem Grade erweicht, dass eine Mehrzahl von Partikeln wenigstens teilweise in dem erweichten Bereich des Substrats eingebettet wird. Anschließend wird wenigstens ein Teil des Substrats gehärtet, so dass wenigstens ein Partikel sicher im Substrat eingebettet wird. Es wird ausgeführt, dass die Anwendung von Wärme die Einbettung von Partikeln unterstützen kann. Das Einbetten von Kohlenstoffpartikeln wie Kohlenstoffnanoröhren in Elastomere wird nicht konkret beschrieben. Die Beispiele in dieser Patentanmeldung behandeln das Einbetten von Silber-Nanopartikeln in Polyvinylchlorid.

Es besteht folglich weiterhin der Bedarf an verbesserten Verfahren zur Herstellung von dehnbaren Elektroden mit in die Elastomeroberfläche eingebrachten leitfähigen Kohlenstoffpartikeln. Wünschenswert wären auch Herstellungsverfahren für solche funktionalisierten Elastomeroberflächen, welche bei einer wiederkehrenden Dehnung und Entlastung die elektrische Leitfähigkeit nicht völlig verlieren.

Erfindungsgemäß vorgeschlagen wird daher ein Verfahren zur Herstellung von dehnbaren Elektroden mit einer elektrisch leitfähige Kohlenstoffteilchen umfassenden Oberflächenschicht, umfassend die Schritte:
(A) Bereitstellen eines Elastomers mit einer Glasübergangstemperatur T_{g} von ≥ 130 °C bis ≤ 0 °C und wobei weiterhin in dem Elastomer die Spannung σ bei zunehmender Dehnung nicht abfällt;
(B) Bereitstellen einer Zubereitung von nicht aggregierten Kohlenstoffteilchen mit einem mittleren Teilchendurchmesser von ≥ 0,3 nm bis ≤ 3000 nm in einem Lösungsmittel, welches in der Lage ist, das Aufquellen einer Oberflächenschicht des Elastomers zu bewirken;
(C) Kontaktieren der Oberflächenschicht des Elastomers mit der Zubereitung der Kohlenstoffteilchen;
(D) Einwirken der Zubereitung der Kohlenstoffteilchen auf Oberflächenschicht des Elastomers für eine Zeitdauer, welche nicht ausreicht, um das Elastomer in Lösung zu überführen; und
(E) Beenden des Einwirkens der Zubereitung der Kohlenstoffteilchen auf die Oberflächenschicht des Elastomers.

Elektrisch leitfähige Teilchen im Sinne der vorliegenden Erfindung sind zunächst alle Teilchen aus einem Material, welches kein Isolator ist. Typischerweise werden als Isolatoren Substanzen bezeichnet, welche eine elektrische Leitfähigkeit von weniger als 10⁻⁸ S/m aufweisen. Die Teilchen werden in eine ein Elastomer umfassende Oberflächenschicht eingebracht, was bedeutet, dass nicht unbedingt nur die Oberfläche selbst mit den Teilchen belegt wird, sondern auch das unmittelbar unterhalb der Oberfläche liegende Material die Teilchen aufnimmt. Demzufolge bedeutet im Rahmen der Erfindung der Begriff der Oberflächenschicht, im Gegensatz zur zweidimensionalen Oberfläche, eine dreidimensionale Materialschicht, welche die Oberfläche als eine ihrer Begrenzungen mit einschließt. Die Oberflächenschicht wird zum Inneren des betreffenden Gegenstands zumindest dadurch abgegrenzt, dass sie eben diese elektrisch leitfähigen Partikel enthält.

In Schritt (A) wird ein Elastomer bereitgestellt. Elastomere im Zusammenhang der vorliegenden Erfindung sind formfeste, aber elastisch verformbare Kunststoffe. Es ist vorgesehen, dass das Elastomer eine Glasübergangstemperatur T_{g} von ≥ -130 °C bis ≤ 0 °C aufweist. Die Glasübergangstemperatur lässt sich anhand der Norm DIN EN ISO 6721-1 bestimmen und kann auch in einem Bereich von ≥ -80 °C bis ≤ -10 °C oder von ≥ -78 °C bis ≤ -30 °C liegen. Weiterhin ist vorgesehen, dass in dem Elastomer die Spannung σ bei zunehmender Dehnung nicht abfällt. Hierunter ist das Verhalten der Spannung σ bei der beabsichtigten Einsatztemperatur der Elektrode zu verstehen. Dieses bedeutet insbesondere, dass in einem Spannungs-DehnungsDiagramm die Kurve für die Spannung σ kein lokales Maximum aufweist. Mit anderen Worten zeigen die Elastomere keinen Yield-Punkt in der Spannungs-Dehnungs-Kurve. Besonders geeignete Elastomere haben eine mit zunehmender Dehnung progressiv ansteigende Spannung σ, ohne einen Yield-Punkt in der Spannungs-Dehnungskurve zu zeigen. Vorzugsweise fällt in dem Elastomer die Spannung σ bei zunehmender Dehnung nicht ab.

Geeignete Elastomere können, ohne hierauf beschränkt zu sein, eine Shore A-Härte gemäß ISO 868 von ≥ 20 bis ≤ 100 besitzen. Die Kunststoffe können sich bei Zug- und Druckbelastung elastisch verformen und Zugfestigkeiten gemäß DIN 53 504 im Bereich von ≥ 10 kPa bis ≤ 60 MPa aufweisen. Nach der Belastung finden sie wieder weitgehend in ihre ursprüngliche, unverformte Gestalt zurück. Gute Elastomere zeigen nur geringe bleibende Dehnung und kein merkliches Kriechen unter mechanischer Dauerlast. Vorzugsweise liegt die Kriechneigung gemäß DIN EN 10 291 bei ≤ 20 % und mehr bevorzugt bei ≤ 5 %.

Schritt (B) beinhaltet das Bereitstellen einer Zubereitung von nicht aggregierten Kohlenstoffteilchen. Dieses bedeutet, dass die Teilchen in dem Lösungsmittel vereinzelt vorliegen oder zumindest so wenig aggregiert sind, dass die Zubereitung stabil ist. In einer stabilen Zubereitung tritt hierbei in einer Lagerung bei Raumtemperatur für einen Zeitraum von mindestens einem Tag, vorzugsweise eine Woche oder vier Wochen, keine Ausflockung oder Ausfällung der Kohlenstoffteilchen ein. Um eine solche Zubereitung herzustellen, können die vorhandenen Aggregate der Kohlenstoffteilchen durch Energieeintrag, beispielsweise mittels Ultraschall, Mahlprozesse oder hohen Scherkräften, aufgebrochen werden. Letztendlich wird das Lösungsmittel danach ausgewählt, dass es sowohl die Zubereitung der Kohlenstoffteilchen bilden kann, als auch die Elastomeroberfläche zum Quellen bringen kann.

Der mittlere Teilchendurchmesser kann auch in einem Bereich von ≥ 1 nm bis ≤ 1000 nm oder von ≥ 3 nm bis ≤ 100 nm liegen. Die Bestimmung kann beispielsweise mittels Rasterelektronenmikroskopie oder dynamischer Lichtstreuung erfolgen.

Das Lösungsmittel kann ein wässriges oder ein nicht-wässriges Lösungsmittel sein. Im letzteren Fall ist es vorzugsweise ein polares, aprotisches Lösungsmittel. Auf diese Weise kann das Lösungsmittel gut mit Weichsegmentdomänen im Elastomer wechselwirken. Der Begriff "nichtwässrig" bedeutet, dass dem Lösungsmittel kein zusätzliches Wasser hinzugefügt wurde, schließt aber die technisch unvermeidlichen Wasserspuren, beispielsweise bis zu einer Menge von ≤ 5 Gewichts-%, vorzugsweise ≤ 3 Gewichts-% und mehr bevorzugt ≤ 1 Gewichts-%, nicht aus.

Ist das Lösungsmittel ein wässriges Lösungsmittel, so können die Kohlenstoffteilchen durch Zugabe von Tensiden oder anderen oberflächenaktiven Stoffen desagglomeriert und in Dispersion gehalten werden.

Die Kohlenstoffteilchen können in dem Lösungsmittel in einer Konzentration von beispielsweise > 0,01 Gewichts-% bis ≤ 20 Gewichts-%, ≥ 0,1 Gewichts-% bis ≤ 15 Gewichts-% oder ≥ 0,04 Gewichts-% bis ≤ 5 Gewichts-% vorliegen.

Das Kontaktieren der ein Elastomer umfassenden Oberflächenschicht mit der Zubereitung der Kohlenstoffteilchen in Schritt (C) erfolgt naturgemäß über die Oberfläche des Elastomers.

Im darauffolgenden Schritt (D) wirkt die Zubereitung der Kohlenstoffteilchen auf die Oberflächenschicht ein. Ohne auf eine Theorie festgelegt zu sein, wird angenommen, dass hierbei durch das Lösungsmittel die Oberfläche des Elastomers aufquillt, sich Poren in der Oberflächenschicht bilden und dass Kohlenstoffteilchen in diese Poren hineinwandern können. Bei wässrigen oder wasserhaltigen Lösungsmitteln wird das Aufquellen des Elastomers dann begünstigt, wenn in dem Polymer hydrophile Domänen vorliegen. Die Teilchen können beispielsweise bis zu einer Tiefe von ≤ 10 µm, ≤ 1 µm oder ≤ 0,3 µm in die Oberflächenschicht eindringen.

Die Einwirkzeit wird so gewählt, dass das Elastomer der Oberflächenschicht nicht in Lösung überführt wird. Hierin mit eingeschlossen sind technisch unvermeidliche Lösungsvorgänge, bei denen beispielsweise ≤ 1 Gewichts-%, ≤ 0,1 Gewichts% oder ≤ 0,01 Gewichts-% des Elastomers in das Lösungsmittel übergehen. Das erfindungsgemäße Verfahren ist aber gerade kein Verfahren, bei dem zunächst das Polymer homogen gelöst wird und dann zusammen mit Nanopartikeln durch Entfernen des Lösungsmittels die fertigen Partikel in der Matrix erhalten wird. Vielmehr wird die Einwirkzeit so gewählt, dass ein Aufquellen der Polymeroberfläche stattfinden kann. Beispiele für geeignete Einwirkzeiten sind ≥ 1 Sekunde bis ≤ 360 Minuten, vorzugsweise ≥ 1 Minuten bis ≤ 90 Minuten, mehr bevorzugt ≥ 3 Minuten bis ≤ 10 Minuten.

Schritt (E) schließlich beinhaltet das Beenden des Einwirkens der Zubereitung der Kohlenstoffteilchen auf die Oberflächenschicht. Somit wird also die Zubereitung der Kohlenstoffteilchen von der Oberflächenschicht wieder getrennt. Anschließend kann die Oberflächenschicht gespült werden, um anhaftende Zubereitung zu entfernen. Dieses kann unter anderem dadurch geschehen, dass der Elastomer-Gegenstand mit der zu modifizierenden Oberflächenschicht aus einem Tauchbad entfernt wird. Danach kann der Gegenstand beispielsweise mit Aceton abgespült werden.

Vorteilhafterweise schließt sich an Schritt (E) ein Trocknungsschritt an, bei dem das in der aufgequollenen Oberflächenschicht befindliche Lösungsmittel entfernt wird, wobei sich die Poren im Elastomer schließen und die Kohlenstoffteilchen im Polymer eingeschlossen werden.

Das erfindungsgemäße Verfahren bietet die Möglichkeit, für die Herstellung einer dehnbaren Elektrode gezielt die Oberflächenschicht eines Elastomer-Gegenstands mit einer elektrisch leitfähigen Oberfläche zu versehen. Dadurch, dass das im Verfahren funktionalisierte Elastomer erfindungsgemäß ausgewählt ist, eignet sich die Elektrode auch für zyklische Belastungen. Im Verfahren wird die Form des Gegenstands nicht durch Auflösen zerstört, so dass auch fertige Formteile behandelt werden können. Da die Partikel im oberflächennahen Bereich des Gegenstands konzentriert sind, wird insgesamt eine geringere Menge benötigt, um eine elektrisch leitende Elastomeroberfläche zu erhalten. Schließlich müssen, im Gegensatz zu lösungsbasierten Verfahren, keine großen Mengen an Lösungsmitteln entfernt werden, um das fertige modifizierte Polymer zu erhalten. Auch ist es möglich, die Konzentration der Kohlenstoffpartikel in einem Bereich zu halten, bei dem kein technisch nachteiliger Viskositätsanstieg eintritt.

Eine weiterer vorteilhafter Aspekt des erfindungsgemäßen Verfahrens zur Herstellung dehnbarer Elektroden ist die Behandlung von Elastomer-Formteilen, welche anschließend durch eine elektrostatische Pulverbeschichtung lackiert werden sollen oder die galvanisiert werden sollen. Die elektrisch leitfähigen Teilchen in der Oberflächenschicht sorgen hierbei für einen verbesserten elektrostatischen Pulverauftrag. Eine weitere Anwendung betrifft das Behandeln von Elastomer-Formteilen zur Vorbereitung einer Elektrotauchlackierung. Es lassen sich auch leitfähige Elektrodenmaterialien oder elastische Kondensatoren erhalten. Weiterhin können elektronische Bauteile oder Kabelummantelungen mit einer antistatischen Beschichtung versehen werden.

In einer Ausführungsform des erfindungsgemäßen Verfahrens umfasst dieses weiterhin den Schritt:
(F) Auftragen einer zusätzlichen elektrisch leitfähigen Schicht auf die in den Schritten (B) bis
(E) erhaltene, elektrisch leitfähige Kohlenstoffteilchen umfassende Oberflächenschicht, wobei die erhaltene zusätzliche elektrisch leitfähige Schicht bei einer Dehnung der Oberflächenschicht vor dieser aufbricht oder reißt.

Die zusätzliche elektrisch leitfähige Schicht in Schritt (F) kann beispielsweise ein leitfähiger Lack, eine Leitfähigkeitspaste, eine Metallschicht oder eine Schicht eines elektrisch leitfähigen Polymers sein. Beispiele für Metalle sind Gold, Silber, Kupfer und/oder Zinn. Beispiele für elektrisch leitfähige Polymere sind Polythiophene, insbesondere das üblicherweise als PEDOT oder PEDT bezeichnete Poly-(3,4-Ethylendioxythiophen). Das Auftragen der Metalle kann zum Beispiel durch chemische Abscheidung aus der Gasphase, physikalische Abscheidung aus der Gasphase oder Sputtern geschehen. Bevorzugt ist hierbei das Aufsputtern von Gold. Das Auftragen der elektrisch leitfähigen Polymere kann mittels einer Polymerlösung, gefolgt vom Verdampfen des Lösungsmittels, erfolgen. Weitere mögliche Materialien für die zusätzliche Schicht sind Indium-Zinn-Oxid (ITO), Fluordotiertes Zinn(IV)-Oxid (FTO), Aluminiumdotiertes Zinkoxid (AZO) und/oder Antimondotiertes Zinn(IV)-Oxid (ATO).

Die zusätzliche elektrische Schicht kann, ohne hierauf beschränkt zu sein, eine Dicke von ≥ 10 nm bis ≤ 10 µm oder von ≥ 20 nm bis ≤ 1 µm aufweisen.

Das Material der zusätzlichen elektrisch leitfähigen Schicht wird so ausgewählt, dass die zusätzliche Schicht bei einer Dehnung der Oberflächenschicht zuerst aufbricht oder reißt. Vorteilhaft hieran ist, dass durch den Kontakt der aufgebrochenen oder gerissenen Beschichtung mit der Kohlenstoffteilchen umfassenden Oberflächenschicht die elektrische Leitfähigkeit des Gesamtsystems nicht abrupt zusammenbricht, sondern noch zu einem gewissen Maße aufrechterhalten wird. Mit anderen Worten nimmt die Leistungsdichte einer dehnbaren Elektrode mit der Zeit durch die Belastung zwar ab, erlischt aber nicht vollständig. Dieses Verhalten ist insbesondere günstig, wenn das Elastomer zyklischer Dehnung und Entlastung unterworfen wird und die ganze Zeit über eine elektrische Leitfähigkeit gefordert wird.

In einer bevorzugten Ausführungsform des erfindungsgemäßen Verfahrens findet in Schritt (D) das Einwirken der Zubereitung der Kohlenstoffteilchen auf die Oberflächenschicht des Elastomers unter Einsatz von Ultraschall und/oder Wärme statt. Der Energieeintrag durch Ultraschall und/oder Wärme wirkt zum Einen der Bildung von Partikelaggregaten entgegen und ermöglicht somit höhere Partikelkonzentrationen in der Lösung. Weiterhin wird das Einbringen der Partikel in die Elastomer-Oberflächenschicht beschleunigt. Vorteilhafterweise liegt beim Ultraschall die Frequenz bei ≥ 0 kHz bis ≤ 20 MHz und unabhängig davon die Leistungsdichte im Lösungsmittel ≥ 1 W/l bis ≤ 200 W/1. Bei einer Erwärmung während der Einwirkung kann die Temperatur beispielsweise ≥ 30 °C bis ≤ 200 °C, bevorzugt ≥ 40 °C bis ≤ 150 °C betragen.

Es ist möglich, dass die eingesetzten Kohlenstoffteilchen im Anschluss an ihre Herstellung an der Oberfläche nicht weiter kovalent funktionalisiert sind. Dieses bedeutet, dass die Teilchen keine zusätzlichen, über weitere Reaktionsschritte kovalent angebundenen funktionellen Gruppen an ihrer Oberfläche tragen. Insbesondere vermieden wird der Einsatz von Oxidationsmitteln wie Salpetersäure, Wasserstoffperoxid, Kaliumpermanganat und Schwefelsäure oder eine mögliche Mischung dieser Mittel für die Funktionalisierung der Kohlenstoffteilchen. Vorteilhaft am Einsatz nicht kovalent funktionalisierter Teilchen ist, dass das π-Elektronensystem der Oberfläche nicht gestört wird und daher uneingeschränkt zur elektrischen Leitfähigkeit beitragen kann.

In einer weiteren Ausführungsform des erfindungsgemäßen Verfahrens sind die Kohlenstoffteilchen ausgewählt aus der Gruppe umfassend Kohlenstoff-Nanoröhren, einwandige Kohlenstoff-Nanoröhren, mehrwandige Kohlenstoff-Nanoröhren, Kohlenstoff-Nanohörner, Kohlenstoff-Nanozwiebeln, Fullerene, Graphit, Graphen, Kohlenstoff-Fasem, Ruß und/oder Leitruß. Diese Teilchen können neben einer Erhöhung der elektrischen Leitfähigkeit auch mechanische Eigenschaften der Oberflächenschicht, wie zum Beispiel Elastizität und Schlagzähigkeit, verbessern.

Kohlenstoffnanoröhren im Sinne der Erfindung sind alle einwandigen oder mehrwandigen Kohlenstoffnanoröhren vom Zylinder-Typ, Scroll-Typ, Multiscroll-Typ oder mit zwiebelartiger Struktur. Bevorzugt sind mehrwandige Kohlenstoffnanoröhren vom Zylinder-Typ, Scroll-Typ, Multiscroll-Typ oder deren Mischungen einzusetzen. Günstig ist es, wenn die Kohlenstoffnanoröhren ein Verhältnis von Länge zu Außendurchmesser von ≥ 5, bevorzugt ≥100 haben.

Im Unterschied zu den bereits erwähnten bekannten Kohlenstoffnanoröhren vom Scroll-Typ mit nur einer durchgehenden oder unterbrochenen Graphenlage existieren auch Kohlenstoffnanoröhren-Strukturen, die aus mehreren Graphenlagen bestehen, welche zu einem Stapel zusammengefasst und aufgerollt vorliegen. Man spricht hierbei vom Multiscroll-Typ. Diese Kohlenstoffnanoröhren werden in DE 10 2007 044031 A1 beschrieben, auf die in vollem Umfang Bezug genommen wird. Diese Struktur verhält sich zu den Kohlenstoffnanoröhren vom einfachen Scroll-Typ vergleichsweise wie die Struktur mehrwandiger zylindrischer Kohlenstoffnanoröhren (cylindrical MWNT) zur Struktur der einwandigen zylindrischen Kohlenstoffnanoröhren (cylindrical SWNT).

Anders als bei den zwiebelartigen Strukturen (onion type structure) verlaufen die einzelnen Graphen- beziehungsweise Graphitschichten in diesen Kohlenstoffnanoröhren im Querschnitt gesehen offenbar durchgehend vom Zentrum der Kohlenstoffnanoröhren bis zum äußeren Rand ohne Unterbrechung. Dies kann zum Beispiel eine verbesserte und schnellere Interkalierung anderer Materialien im Röhrchengerüst ermöglichen, da mehr offene Ränder als Eintrittszone der Interkalate zur Verfügung stehen im Vergleich zu Kohlenstoffnanoröhren mit einfacher Scrollstruktur (Carbon 1996, 34, 1301-3) oder CNTs mit zwiebelartiger Struktur (Science 1994, 263, 1744-7).

Vorzugsweise sind die Kohlenstoffteilchen nicht kovalent funktionalisierte, mehrwandige Kohlenstoff-Nanoröhren mit einem Durchmesser von ≥ 3 nm bis ≤ 100 nm. Der Durchmesser bezieht sich hierbei auf den mittleren Durchmesser der Nanoröhren. Er kann auch in einem Bereich von ≥ 5 nm bis ≤ 80 nm und vorteilhafterweise von ≥ 6 nm bis ≤ 60 nm liegen. Die Länge der Nanoröhren ist zunächst nicht begrenzt. Sie kann aber beispielsweise in einem Bereich von ≥ 1 µm bis ≤ 100 µm und vorteilhafterweise von ≥ 10 µm bis ≤ 30 µm liegen.

In einer weiteren Ausführungsform des erfindungsgemäßen Verfahrens ist das Lösungsmittel ausgewählt aus der Gruppe umfassend Methanol, Ethanol, Isopropanol, Butanol, Ethylenglykol, Propylenglykol, Butylenglykol, Glycerin, Hydrochinon, Aceton, Ethylacetat, Trichlorethylen, Trichlorethan, Trichlormethan, Methylenchlorid, Cyclohexanon, N,N-Dimethylformamid, Dimethylsulfoxid, Tetrahydrofuran, N-Methyl-2-pyrrolidon, Benzol, Toluol, Chlorbenzol, Styrol, Polyesterpolyole, Polyetherpolyole, Methylethylketon, Ethylenglykolmonobutylether, Diethylenglykol, Gemische der vorgenannten Lösungsmittel untereinander und/oder Mischungen der vorgenannten Lösungsmittel mit Wasser.

Diese Lösungsmittel vereinigen in besonderer Weise die Fähigkeit, aggregatarme oder aggregatfreie Lösungen mit den Kohlenstoffteilchen zu bilden und dabei bei auf das Polymer abgestimmter Auswahl gleichzeitig zu einem Aufquellen der Elastomeroberfläche zu führen. Mischungen der vorgenannten Lösungsmittel betreffen solche Fälle, in denen das Lösungsmittel im gewünschten Massenanteil auch in Wasser löslich ist.

Das Kontaktieren der ein Elastomer umfassenden Oberflächenschicht mit der Zubereitung der Kohlenstoffteilchen kann unter anderem durch Eintauchen, Auftragen, Bedrucken, Bestreichen, Besprühen und/oder Begießen erfolgen. Durch Eintauchen in ein Tauchbad lassen sich beispielsweise Gegenstände leicht vollständig behandeln. Auch kann leicht ein kontinuierlicher Prozess zur Herstellung eines so behandelten Polymerfilms realisiert werden. Das Bedrucken von Elastomer-Gegenständen, zum Beispiel im Siebdruckverfahren, erlaubt das Darstellen von elektrisch leitfähigen Strukturen wie Leiterbahnen am Elastomer-Gegenstand.

In einer weiteren Ausführungsform des erfindungsgemäßen Verfahrens ist das Elastomer ausgewählt aus der Gruppe umfassend Polyacrylat, Acrylester-Kautschuk, Polyacrylnitril, Poly(acrylnitril-co-Butydien-co-Styrol), Poly(acrylnitril-co-Methylmethacrylat), Polyamid, Polyamidimid, Polyester, Polyetheretherketon, Polyetherester, Polyethylen, Ethylen-Propylen-Kautschuk, Poly(ethylen-co-Tetrafluorethylen), Poly(ethylen-co-Vinylacetat), Poly(ethylen-co-Vinylalkohol), Fluor-Silikone, Perfluoralkoxypolymer, (Natur-)Kautschuk, Poly(methylmethacrylat-co-Acrylnitril-co-Butadien-co-Styrol), Poly(methylmethacrylat-co-Butadien-co-Styrol), Nitrile, Olefine, Polyphosphazene, Polypropylen, Poly(methylmethacrylat), Polyurethane, Polyvinylchlorid, Polyvinylfluoride und/oder Silikone.

In einer weiteren Ausführungsform des erfindungsgemäßen Verfahrens ist zumindest in Schritt (D) die Oberflächenschicht des Elastomers teilweise durch eine Maske abdeckt. Durch die Maske werden Teilbereiche der Oberfläche abgedeckt und andere Bereiche freigelassen. Auf diese Weise lassen sich elektrisch leitfähige Strukturen auf der Elastomeroberfläche wie Leiterbahnen und dergleichen darstellen.

Die erfindungsgemäß erhaltene Elastomer-Oberfläche kann beispielsweise einen spezifischen Widerstand der Oberflächenschicht von ≥ 10⁻³ Ohm cm bis ≤ 10⁸ Ohm cm aufweisen. Der spezifische Widerstand lässt sich anhand der Norm ASTM D 257 bestimmen. Vorzugsweise liegt dieser Widerstand in einem Bereich von ≥ 1 Ohm cm bis ≤ 1000000 Ohm cm, mehr bevorzugt von ≥ 10 Ohm cm bis ≤ 100000 Ohm cm. Die zur Berechnung des spezifischen Widerstands ρ benötigte Schichtdicke lässt sich aus Elektronenmikroskop-Aufnahmen eines Probenquerschnitts erhalten.

Die vorliegende Erfindung betrifft ebenfalls eine dehnbare Elektrode, umfassend ein Elastomer mit einer durch ein erfindungsgemäßes Verfahren erhältlichen, elektrisch leitfähige Kohlenstoffteilchen umfassenden Oberflächenschicht, wobei das Elastomer eine Glasübergangstemperatur T_{g} von ≥ -130 °C bis ≤ 0 °C aufweist und wobei weiterhin in dem Elastomer die Spannung σ bei zunehmender Dehnung nicht abfällt. Bezüglich der Elastomere und geeigneter Ausführungsformen der Elastomere wird zur Vermeidung von Wiederholungen auf die Ausführungen zum erfindungsgemäßen Verfahren verwiesen.

Erfindungsgemäße dehnbare Elektroden sind beispielsweise nützlich in Elastomer-Formteilen, welche anschließend durch eine elektrostatisches Pulverbeschichtung oder Elektrotauchlackierung lackiert werden sollen oder die galvanisiert werden sollen. Andere Beispiele sind allgemein elektronische Bauteile oder Kabelummantelungen mit einer antistatischen Beschichtung. Besonders bevorzugte Verwendungen sind weiter unten angegeben.

In einer Ausführungsform der erfindungsgemäßen Elektrode liegen die Kohlenstoffieilchen in der Oberflächenschicht bis zu einer Tiefe von ≤ 10 µm unterhalb der Oberfläche angeordnet vor.

Bei der Berechnung der Eindringtiefe wird die zusätzliche elektrisch leitfähige Schicht nicht mit berücksichtigt. Wie bereits ausgeführt, umfasst die Oberflächenschicht ein Elastomer. Vorteilhafterweise bilden die Teilchen in dieser Oberflächenschicht ein Netzwerk aus, so dass eine elektrische Leitfähigkeit eintritt. Die Teilchen können auch bis zu einer Tiefe von ≤ 5 µm oder ≤ 1 µm unterhalb der Oberfläche angeordnet vorliegen. Erfindungsgemäß mit eingeschlossen sind auch Gegenstände, welche die mit Kohlenstoffteilchen ausgestattete Elastomer-Oberflächenschicht umfassen und zusätzlich noch weitere Materialien aufweisen. Es kann sich beispielsweise um Gebrauchsgegenstände handeln, welche zumindest teilweise eine Elastomer-Oberfläche umfassen und wobei in diese Oberfläche beziehungsweise Elastomer-Oberflächenschicht die elektrisch leitfähigen Kohlenstoffteilchen eingebracht wurden.

In einer weiteren Ausführungsform der erfindungsgemäßen Elektrode liegen die Kohlenstoffteilchen innerhalb des sie umfassenden Elastomermaterials der Oberflächenschicht in einem Anteil von ≥ 0,1 Gewichts-% bis ≤ 10 Gewichts-% vor. Der Anteil kann auch in einem Bereich von ≥ 0,5 Gewichts-% bis ≤ 4 Gewichts-% oder von ≥ 1 Gewichts-% bis ≤ 5 Gewichts-% liegen. Letztendlich wird hierdurch also der Gehalt an Kohlenstoffteilchen in der Oberflächenschicht angegeben. Die Grenze der Oberflächenschicht im Inneren des Gegenstands, ab der das Elastomermaterial nicht mehr in die Berechnung einfließt, wird durch die unterste (innerste) Linie, bis zu der die Kohlenstoffteilchen im vorkommen, gebildet. Innerhalb der angegebenen Bereiche lässt sich die Perkolationsgrenze für die Kohlenstoffteilchen überschreiten, so dass die elektrische Leitfähigkeit stark verbessert wird.

In einer weiteren Ausführungsform der erfindungsgemäßen Elektrode weist diese einen spezifischen Widerstand der Oberflächenschicht von ≥ 10⁻³ Ohm cm bis ≥ 10⁸ Ohm cm auf. Der spezifische Widerstand lässt sich anhand der Norm ASTM D 257 bestimmen. Vorzugsweise liegt dieser Widerstand in einem Bereich von ≥ 1 Ohm cm bis ≤ 1000000 Ohm cm, mehr bevorzugt von ≥ 10 Ohm cm bis ≤ 100000 Ohm cm.

In einer weiteren Ausführungsform der erfindungsgemäßen Elektrode sind die Kohlenstoffteilchen unfunktionalisierte, mehrwandige Kohlenstoff-Nanoröhren mit einem Durchmesser von ≥ 3 nm bis ≤ 100 nm. Der Durchmesser bezieht sich hierbei auf den mittleren Durchmesser der Nanoröhren. Er kann auch in einem Bereich von ≥ 5 nm bis ≤ 80 nm und vorteilhafterweise von ≥ 6 nm bis ≤ 60 nm liegen. Die Länge der Nanoröhren ist zunächst nicht begrenzt. Sie kann aber beispielsweise in einem Bereich von ≥ 1 µm bis ≤ 100 µm und vorteilhafterweise von ≥ 10 µm bis ≤ 30 µm liegen.

In einer weiteren Ausführungsform der erfindungsgemäßen Elektrode weist dieser eine ersten und eine zweiten elektrisch leitfähige Kohlenstoffteilchen umfassende Oberflächenschicht auf, wobei die besagte erste und zweite Oberflächenschicht einander gegenüberliegend angeordnet sind und durch eine Elastomerschicht voneinander getrennt sind. Bedingt durch das Herstellungsverfahren sind die erste und die zweite Oberflächenschicht integral mit der trennenden, elektrisch isolierenden Elastomer verbunden. Durch solch einen Aufbau von zwei durch ein Dielektrikum getrennten elektrisch leitfähigen Schichten kann ein elastischer Kondensator realisiert werden. Unmittelbar auf der ersten und/oder der zweiten Oberflächenschicht ist dann eine bereits vorstehend erwähnte zusätzliche elektrisch leitfähige Schicht angeordnet.

In einer weiteren Ausführungsform der erfindungsgemäßen Elektrode umfasst diese eine auf der elektrisch leitfähige Kohlenstoffteilchen umfassenden Oberflächenschicht angeordnete zusätzliche elektrisch leitfähige Schicht, wobei die zusätzliche elektrisch leitfähige Schicht bei einer Dehnung der Oberflächenschicht vor dieser aufbricht oder reißt.

Die zusätzliche elektrische Schicht kann beispielsweise ein leitfähiger Lack, eine Leitfähigkeitspaste, eine Metallschicht oder eine Schicht eines elektrisch leitfähigen Polymers sein. Beispiele für Metalle sind Edelmetalle, Kupfer und/oder Zinn. Die zusätzliche elektrische Schicht kann, ohne hierauf beschränkt zu sein, eine Dicke von ≥ 10 nm bis ≤ 50 µm oder von ≥ 20 nm bis ≤ 10 µm aufweisen. Das Material der zusätzlichen elektrisch leitfähigen Schicht wird so ausgewählt, dass die zusätzliche Schicht bei einer Dehnung der Oberflächenschicht zuerst aufbricht oder reißt. Vorteilhaft hieran ist, dass durch den Kontakt der aufgebrochenen oder gerissenen Beschichtung mit der Kohlenstoffteilchen umfassenden Oberflächenschicht die elektrische Leitfähigkeit des Gesamtsystems nicht abrupt zusammenbricht, sondern noch zu einem gewissen Maße aufrechterhalten wird. Mit anderen Worten nimmt die Leistungsdichte einer dehnbaren Elektrode mit der Zeit durch die Belastung zwar ab, erlischt aber nicht vollständig. Dieses Verhalten ist insbesondere günstig, wenn das Elastomer zyklischer Dehnung und Entlastung unterworfen wird und die ganze Zeit über eine elektrische Leitfähigkeit gefordert wird.

Vorzugsweise umfasst die zusätzliche elektrisch leitfähige Schicht Gold, Silber, Kupfer, Indium-Zinn-Oxid, Fluordotiertes Zinn(IV)-Oxid, Aluminiumdotiertes Zinkoxid, Antimondotiertes Zinn(IV)-Oxid und/oder Poly-(3,4-Ethylendioxythiophen). Gold kann beispielsweise durch Sputtern aufgetragen werden. Poly-(3,4-Ethylendioxythiophen) wird üblicherweise als PEDOT oder PEDT bezeichnet und kann aus einer Zubereitung des Polymers aufgetragen werden.

Es ist möglich, dass der erfindungsgemäße Elastomer-Gegenstand als Verbund eines Trägermaterials mit der elektrisch leitfähige Kohlenstoffteilchen umfassenden Elastomer-Oberflächenschicht vorliegt. Beispiele für Trägermaterialien sind Keramiken, Metalle, aber auch andere Polymere wie Polycarbonate oder Polyolefine. So kann beispielsweise ein Metall-Formteil zunächst mit dem Elastomer beschichtet werden und anschließend die Elastomer-Oberflächenschicht mit den Kohlenstoffteilchen und der zusätzlichen elektrisch leitfähigen Schicht versehen werden.

Die Erfindung betrifft weiterhin die Verwendung einer erfindungsgemäßen Elektrode als elektromechanischer Wandler, als elektromechanischer Aktor und/oder als elektromechanischer Sensor. Dann ist das Elastomer in der Elektrode ein elektroaktives Polymer und insbesondere ein dielektrisches Elastomer.

Die vorliegende Erfindung wird anhand der nachfolgenden Ausführungsbeispiele in Verbindung mit den Figuren weiter erläutert. Es zeigen:
FIG. 1 eine Elektrodenanordnung mit mehrschichtigem Aufbau
FIG. 2, 3 und 4 Leitfähigkeitsmessungen unter Dehnung für verschiedene Elastomerproben
FIG. 5a, 5b, 6a, 6b, 7a, und 7b Rasterelektronenmikroskop-Aufnahmen verschiedener Elastomerproben

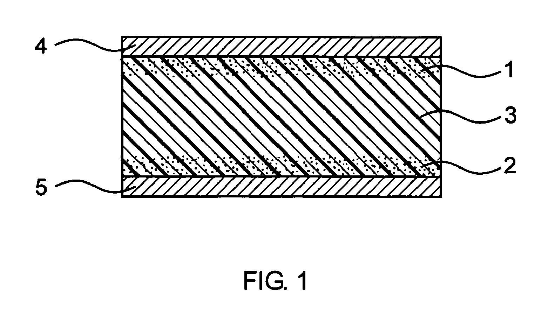

FIG. 1 zeigt schematisch eine erfindungsgemäße Elektrodenanordnung mit mehrschichtigem Aufbau. Ausgehend von einem Elastomer-Werkstück wurden in die obere (1) und die untere (2) Oberflächenschicht des Elastomers Kohlenstoffteilchen wie beispielsweise Kohlenstoffnanoröhren eingebracht. Diese Teilchen sind durch Striche oder Punkte in den jeweiligen Schichten (1, 2) dargestellt. Man erkennt, dass die Teilchen eine begrenzte Eindringtiefe in die Oberflächenschichten aufweisen. Auf den Oberflächenschichten (1, 2) befindet sich jeweils eine zusätzliche elektrisch leitfähige Schicht (4, 5). Die Oberflächenschichten (1, 2) sind durch eine teilchenfreie Elastomerschicht (3) voneinander getrennt. Aufgrund des Herstellungsverfahrens ist die Elektrode in Hinblick auf die Oberflächenschichten (1, 2) immer noch einstückig aufgebaut und die Oberflächenschichten sind stoffschlüssig mit der teilchenfreien Schicht (3) verbunden. Die gezeigten Elektroden können, bei geeigneten Abmessungen, beispielsweise als filmförmiger Kondensator oder als elektroaktives Polymer (EAP) dienen.

### Ausführungsbeispiele:

Die Ausführungsbeispiele betreffen die Funktionalisierung von zwei Elastomeren E1 und E2. Elastomer E1 war ein thermoplastisches Polyurethan (DESMOPAN® 3380A, Firma Bayer MaterialScience AG), mit einer Shore A-Härte gemäß ISO 868 von 80 und einer Glasübergangstemperatur T_{g} von -35 °C. Elastomer E2 war ein Polyurethan, hergestellt aus einem durch Vorverlängerung eines PO-basierten Polyetherpolyols (Acclaim® 6300, Firma Bayer MaterialScience AG) mit Diphenylmethan-4,4'-diisocyanat (Desmodur® 44 M Flakes, Firma Bayer MaterialScience AG) erhaltenen Präpolymers, welches mit einem Polytetramethylenetherglycol (M = 2000 g/mol) abschließend vernetzt wurde. Die Glasübergangstemperatur Tg des Elastomers E2 betrug -65 °C.

Die in den Beispielen erwähnten Kohlenstoffteilchen waren zum einen Kohlenstoffnanoröhren (CNT) in Form von mehrwandigen Kohlenstoffnanoröhren mit dem Handelsnamen BAYTUBES® C 150 P der Firma Bayer MaterialScience AG. Der andere Typ von Kohlenstoffieilchen war Ruß in Form von Leitruß (Ketjenblack 600).

Als Beschichtungsmittel verwendetes PEDOT war Poly-3,4-ethylendioxythiophen mit dem Handelsnamen Clevios P® der Firma HCStarck. Dieses lag als Zubereitung von 0,3 Gewichts-% in vollentsalztem Wasser vor.

Die Tauchlösung wurde durch Beschallung einer definierten Menge Kohlenstoffteilchen im Lösungsmittel mittels Ultraschalllanze hergestellt und unmittelbar eingesetzt. Die Ultraschallfrequenz betrug hierbei 20 kHz und die Leistungsdichte 300 W/kg.

Zur Funktionalisierung der Elastomer-Oberflächen wurden die Proben vollständig in die Tauchzubereitung eingetaucht und mit Ultraschall für eine definierte Zeit in einem Ultraschallbad behandelt. Nach der Entnahme wurde die Oberfläche kurz mit Aceton abgespült, bei Raumtemperatur vollständig getrocknet und anschließend mit einer wässrigen Seifenlösung abgerieben.

Die optionale Beschichtung der so CNT-funktionalisierten Elastomere erfolgte in einem zweiten Schritt durch das Aufdampfen von Gold (Gerät der Firma Cressington, Modell Sputter Coater 108auto) oder das Tauchen für 20 Sekunden in die erwähnte PEDOT-haltige Lösung. Die aufgetragenen Goldschichten waren blickdicht und metallisch glänzend. Daher wurde eine Schichtdicke von über 10 nm angenommen.

An so behandelten Elastomeren wurden Oberflächen- und Volumenwiderstände gemäß der Norm ASTM D 257 gemessen. Des Weiteren wurde der Verlauf des Oberflächenwiderstandes in Abhängigkeit der mechanischen Dehnung gemessen. Hierfür wurden aus den Elastomeren Rechteckstäbe für Zugversuche analog DIN 53504 ausgestanzt und die Klemmen mit elektrisch gegen die Zugmaschine isolierten, gegenüber der Probe leitfähigen Kontakten ausgerüstet. Mit einem konventionellen Multimeter der Firma Keithley, Modell 2400 wurde kontinuierlich während des langsam laufenden Zugversuches, Zuggeschwindigkeit 1 mm/min, der Widerstand über die Probe gemessen und in einem zweiten Schritt die Kraft-Verformungskurve mit der Widerstandmessung über den Zeitstempel der einzelnen Messung synchronisiert.

Die Versuchsbedingungen und die erhaltenen Ergebnisse sind in den nachfolgenden Tabellen wiedergegeben.

| Elastomer | Probe | Füllstoff | c[Gew.-%] | Lösungsmittel | Einwirkzeit [min] |
|---|---|---|---|---|---|
| E1 | a | - | 0 | Aceton | 60 |
| E1 | b | CNT | 0,05 | Aceton | 30 |
| E1 | c | Ruß | 0,05 | Aceton | 10 |
| E1 | d | CNT/Ruß | 0,05/0,05 | Aceton | 10 |
| E1 | e | CNT | 0,5 | Aceton | 10 |
| E2 | a | - | 0 | Aceton | 10 |
| E2 | b | CNT | 0,05 | Aceton | 3 |
| E2 | c | Ruß | 0,05 | Aceton | 3 |
| E2 | d | CNT/Ruß | 0,025/0,025 | Aceton | 3 |

| Elastomer | Probe | Volumenwiderstand [Ohm cm] | Oberflächenwiderstand *R* [Ohm/square] | spezifischer Widerstand ρ [Ohm cm] * |
|---|---|---|---|---|
| E1 | a | 4,0. 10¹² | 7,3 . 10¹⁴ | 2,2 . 10¹⁰ |
| E1 | b | 4,2 · 10⁸ | 7,7 · 10⁵ | 2,3 · 10¹ |
| E1 | c | 2,6 · 10⁸ | 1,7 · 10⁶ | 5,1 · 10¹ |
| E1 | d | 2,8 1·0⁸ | 1,3 · 10⁶ | 3,9 · 10¹ |
| E1 | e | 2,9 · 10⁸ | 3,9 · 10⁵ | 1,2 · 10¹ |
| E2 | a | 1,9 · 10¹¹ | 8,0 · 10¹¹ | 2,4 · 10⁹ |
| E2 | b | 3,6 · 10⁹ | 7,6 · 10⁶ | 2,3 · 10² |
| E2 | c | 5,7 · 10⁸ | 4,2 · 10⁵ | 1,3 · 10¹ |
| E2 | d | 3,5 · 10⁸ | 3,6 · 10⁵ | 1,1 · 10¹ |

| | | | | |
|---|---|---|---|---|
| *: spezifischer Widerstand der Oberflächenschicht; berechnet nach ρ = *R* · d mit einer Schichtdicke d = 0,3 µm | | | | |

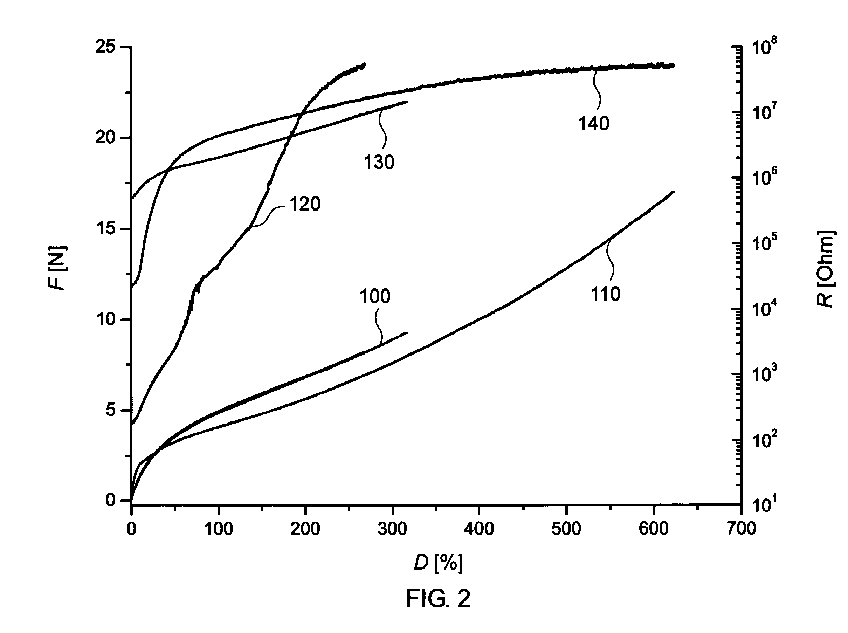

Die Ergebnisse dieser Versuche sind in den Figuren 2, 3 und 4 wiedergegeben. FIG. 2 zeigt für verschiedene Varianten des Elastomers E1e die Abhängigkeit der Kraft F (linke y-Achse) beziehungsweise des Widerstandes des Zugstabes der Probe R (rechte y-Achse) von der Dehnung D (x-Achse). Die Messkurven 100 und 110 beziehen sich auf die Kraft während der Deformation. Kurve 100 ist eine Überlagerung von zwei Kurven, die nahezu deckungsgleich verlaufen. Eine dieser Kurven betrifft die Elastomerprobe E1e ohne weitere Beschichtung, die andere die Elastomerprobe E1e mit Goldschicht. Bei circa 275% Dehnung wurde die Messung für die mit Gold beschichtete Probe E1e abgebrochen, wie man aus der verminderten Dicke der Kurve 100 oberhalb dieser Dehnung ablesen kann. Aus dem Verlauf dieser Kurven ergibt sich, dass die zusätzliche Goldschicht keinen Einfluss auf die mechanischen Eigenschaften des Elastomers ausübt. Die Messkurve 110 bezieht sich auf eine Probe des Elastomers E1e mit einer zusätzlichen Schicht aus PEDOT.

Kurven 120, 130 und 140 geben den Verlauf des Widerstands R in Abhängigkeit der Deformation D für verschiedene Proben des Elastomers E1e wieder. Die Kurve 120 bezieht sich auf eine mit Gold beschichtete Probe. Auch hier wurde bei circa 275% Dehnung die Messung abgebrochen. Kurve 130 bezieht sich auf ein Elastomer E1e ohne weitere Beschichtung. Schließlich betrifft Kurve 140 eine mit PEDOT beschichtete Probe des Elastomers E1e. Deutlich ist zu sehen, dass Elastomer E1e eine nicht verschwindenden Leitfähigkeit unter Deformation aufweist, die mit einer zusätzlichen, leitfähigen Oberflächenschicht in gewissen Deformationsbereichen weiter deutlich verbessert werden kann.

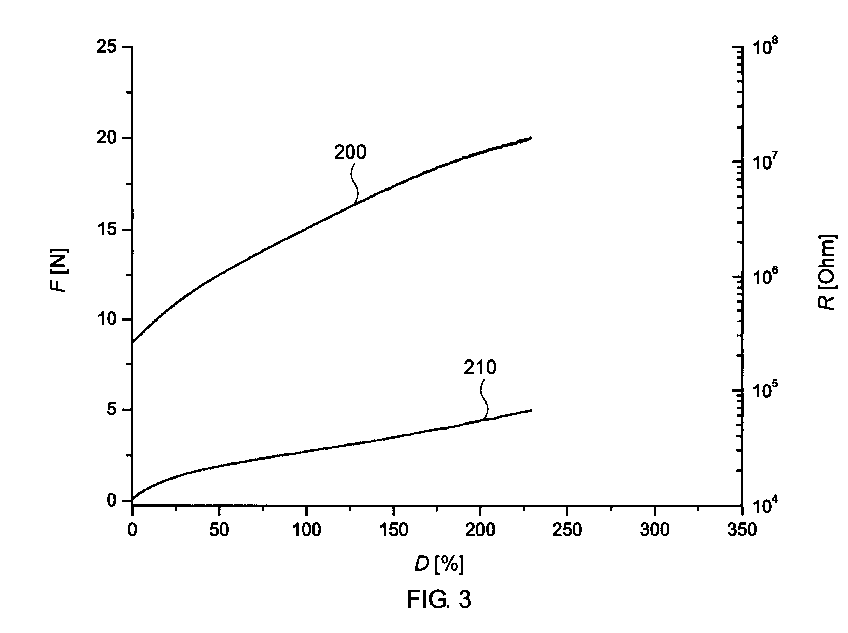

FIG. 3 zeigt nochmals für das Elastomer E1e in Messkurve 210 die Abhängigkeit der Kraft F (linke y-Achse). Eine grobe Abschätzung ergibt, dass sich der Widerstand im gemessenen Dehnungsbereich von circa 230% um etwa zwei Zehnerpotenzen erhöht.

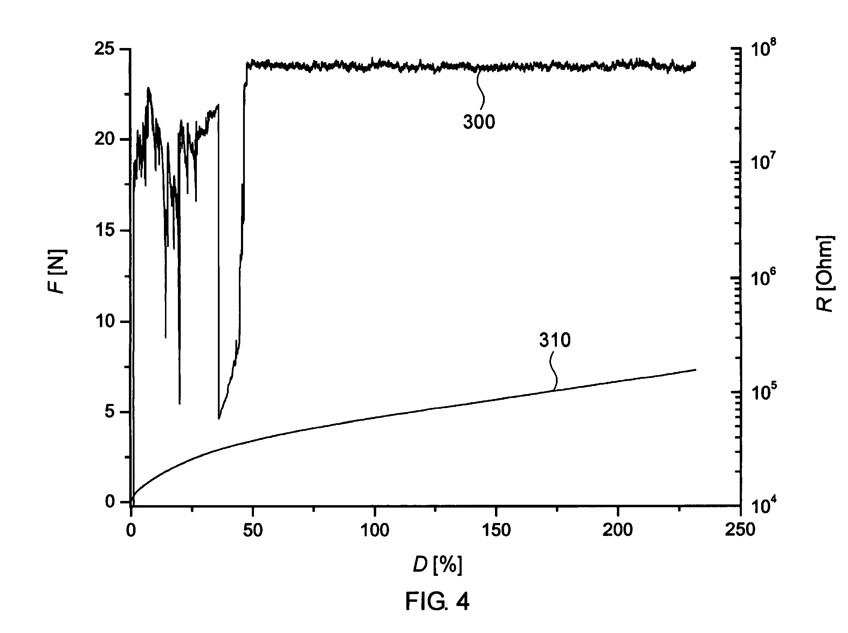

FIG. 4 betrifft eine unbehandelte, nicht mit Kohlenstoffteilchen funktionalisierte Probe des Elastomers E1, welche auch nicht in Aceton getaucht wurde (wie es für eine Probe der Bezeichnung E11 der Fall wäre). Die Figur zeigt für eine beidseitig mit Gold besputterte Probe des Elastomers E1 in Messkurve 310 die Abhängigkeit der Kraft F (linke y-Achse) beziehungsweise in Messkurve 300 des Widerstandes R (rechte y-Achse) von der Dehnung D (x-Achse). Ohne eingebrachte CNT-Schicht im Elastomer bricht bei Deformation die Leitfähigkeit der mit Gold besputterten Probe bereits bei kleinen Deformationen zusammen.

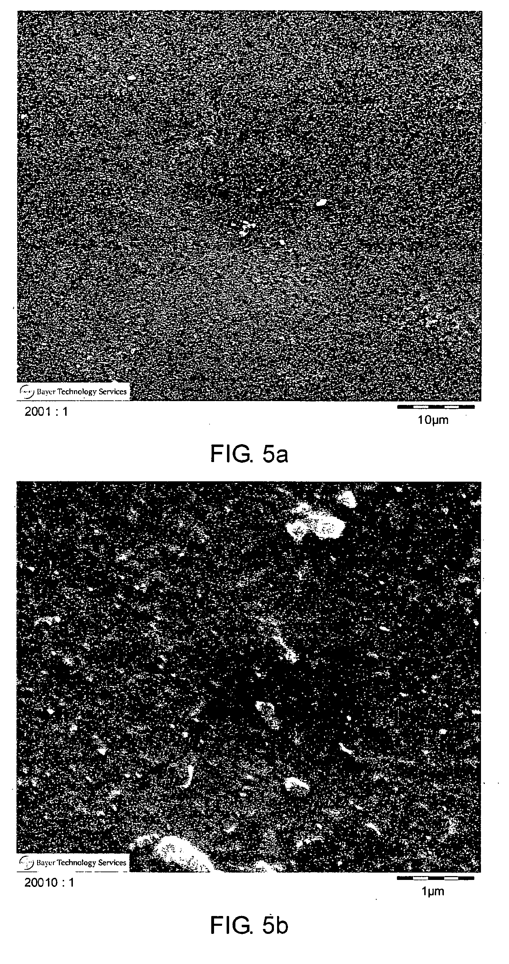

Die Figuren 5a, 5b, 6a, 6b, 7a und 7b zeigen Rasterelektronenmikroskop- (REM-) Aufnahmen von verschiedenen erfindungsgemäßen Proben. Sie wurden mit einem REM vom Typ ESEM Quanta 400 der Firma FEI angefertigt.

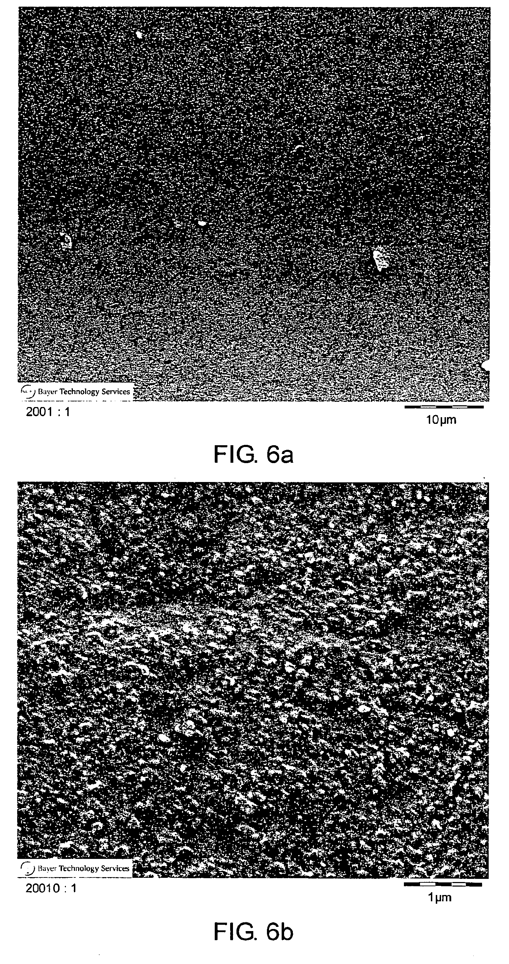

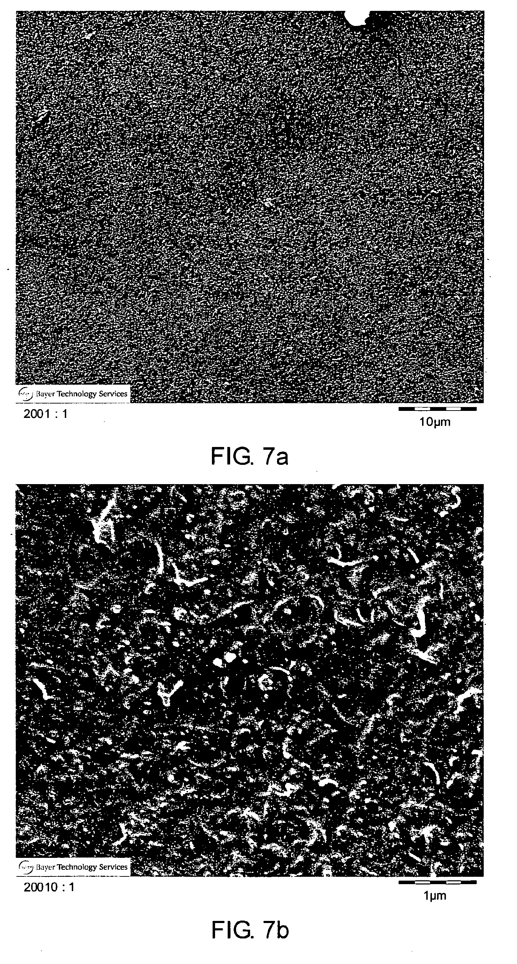

FIG. 5a zeigt eine REM-Aufnahme der Oberfläche einer Probe des Elastomers E2b. Eine vergrößerte Aufnahme dieser Probe ist in FIG. 5b gezeigt. FIG. 6a zeigt eine REM-Aufnahme der Oberfläche einer Probe des Elastomers E2c und FIG. 6b eine vergrößerte Aufnahme dieser Probe. Entsprechend zeigt FIG. 7a zeigt eine REM-Aufuahme der Oberfläche einer Probe des Elastomers vergrößerte REM-Aufnahme der Oberfläche einer Probe des Elastomers E2d.

In den REM-Aufnahmen kann man sehen, dass die Partikel, also Kohlenstoffnanoröhren und/oder Rußpartikel, in die Polymermatrix eingebettet und darin eingeschlossen sind. Die Oberflächen zeigen höchstens eine Reliefstruktur durch die Partikel. Nur gelegentlich stehen lose Nanoröhren-Enden aus der Polymermatrix heraus. Insgesamt wurden die Partikel also fest in die Polymeroberfläche eingebaut.

## Patentansprüche

1. Verfahren zur Herstellung von dehnbaren Elektroden mit einer elektrisch leitfähige Kohlenstoffteilchen umfassenden Oberflächenschicht , umfassend die Schritte:
(A) Bereitstellen eines Elastomers mit einer Glasübergangstemperatur T_{g} von ≥ -130°C bis ≤ 0 °C und wobei weiterhin in dem Elastomer die Spannung σ bei zunehmender Dehnung nicht abfällt;
(B) Bereitstellen einer Zubereitung von nicht aggregierten Kohlenstoffteilchen mit einem mittleren Teilchendurchmesser von ≥ 0,3 nm bis ≤ 3000 nm in einem Lösungsmittel, welches in der Lage ist, das Aufquellen einer Oberflächenschicht des Elastomers zu bewirken;
(C) Kontaktieren der Oberflächenschicht des Elastomers mit der Zubereitung der Kohlenstoffteilchen;
(D) Einwirken der Zubereitung der Kohlenstoffteilchen auf Oberflächenschicht des Elastomers für eine Zeitdauer, welche nicht ausreicht, um das Elastomer in Lösung zu überführen; und
(E) Beenden des Einwirkens der Zubereitung der Kohlenstoffteilchen auf die Oberflächenschicht des Elastomers.

2. Verfahren gemäß Anspruch 1, weiterhin umfassend den Schritt:
(F) Auftragen einer zusätzlichen elektrisch leitfähigen Schicht auf die in den Schritten (B) bis
(E) erhaltene, elektrisch leitfähige Kohlenstoffteilchen umfassende Oberflächenschicht, wobei die erhaltene zusätzliche elektrisch leitfähige Schicht bei einer Dehnung der Oberflächenschicht vor dieser aufbricht oder reißt.

3. Verfahren gemäß Anspruch 1, wobei in Schritt (D) wobei das Einwirken der Zubereitung der Kohlenstoffteilchen auf die Oberflächenschicht des Elastomers unter Einsatz von Ultraschall und/oder Wärme stattfindet.

4. Verfahren gemäß Anspruch 1, wobei die Kohlenstoffteilchen ausgewählt sind aus der Gruppe umfassend Kohlenstoff-Nanoröhren, einwandige Kohlenstoff-Nanoröhren, mehrwandige Kohlenstoff-Nanoröhren, Kohlenstoff-Nanohömer, Kohlenstoff-Nanozwiebeln, Fullerene, Graphit, Graphen, Kohlenstoff-Fasern, Ruß und/oder Leitruß.

5. Verfahren gemäß Anspruch 1, wobei das Lösungsmittel ausgewählt ist aus der Gruppe umfassend Methanol, Ethanol, Isopropanol, Butanol, Ethylenglykol, Propylenglykol, Butylenglykol, Glycerin, Hydrochinon, Aceton, Ethylacetat, Trichlorethylen, Trichlorethan, Trichlormethan, Methylenchlorid, Cyclohexanon, N,N-Dimethylformamid, Dimethylsulfoxid, Tetrahydrofuran, N-Methyl-2-pyrrolidon, Benzol, Toluol, Chlorbenzol, Styrol, Polyesterpolyole, Polyetherpolyole, Methylethylketon, Ethylenglykolmonobutylether, Diethylenglykol, Gemische der vorgenannten Lösungsmittel untereinander und/oder Mischungen der vorgenannten Lösungsmittel mit Wasser.

6. Verfahren gemäß Anspruch 1, wobei das Elastomer ausgewählt ist aus der Gruppe umfassend Polyacrylat, Acrylester-Kautschuk, Polyacrylnitril, Poly(acrylnitril-co-Butydien-co-Styrol), Poly(acrylnitril-co-Methylmethacrylat), Polyamid, Polyamidimid, Polyester, Polyetheretherketon, Polyetherester, Polyethylen, Ethylen-Propylen-Kautschuk, Poly(ethylen-co-Tetrafluorethylen), Poly(ethylen-co-Vinylacetat), Poly(ethylen-co-Vinylalkohol), Fluor-Silikone, Perfluoralkoxypolymer, (Natur-)Kautschuk, Poly(methylmethacrylat-co-Acrylnitril-co-Butadien-co-Styrol), Poly(methylmethacrylat-co-Butadien-co-Styrol), Nitrile, Olefine, Polyphosphazene, Polypropylen, Poly(methylmethacrylat), Polyurethane, Polyvinylchlorid, Polyvinylfluoride und/oder Silikone.

7. Verfahren gemäß Anspruch 1, wobei zumindest in Schritt (D) die Oberflächenschicht des Elastomers teilweise durch eine Maske abdeckt ist.

8. Dehnbare Elektrode, umfassend ein Elastomer mit einer durch ein Verfahren gemäß einem der Ansprüche 1 bis 7 erhältlichen, elektrisch leitfähige Kohlenstoffteilchen umfassenden Oberflächenschicht (1), wobei das Elastomer eine Glasübergangstemperatur T_{g} von ≥ - 130°C bis ≤ 0 °C aufweist und wobei weiterhin in dem Elastomer die Spannung σ bei zunehmender Dehnung nicht abfällt.

9. Elektrode gemäß Anspruch 8, wobei die Kohlenstoffteilchen in der Oberflächenschicht (1) bis zu einer Tiefe von ≤ 10 µm unterhalb der Oberfläche angeordnet vorliegen.

10. Elektrode gemäß Anspruch 8, wobei die Kohlenstoffteilchen innerhalb des sie umfassenden Elastomermaterials der Oberflächenschicht (1) in einem Anteil von ≥ 0,1 Gewichts-% bis ≤ 10 Gewichts-% vorliegen.

11. Elektrode gemäß Anspruch 8 mit einem einen spezifischen Widerstand der Oberflächenschicht (1) von ≥ 10⁻³ Ohm cm bis ≤ 10⁸ Ohm cm.

12. Elektrode gemäß Anspruch 8 mit einer ersten (1) und einer zweiten (2) elektrisch leitfähige Kohlenstoffteilchen umfassenden Oberflächenschicht, wobei die besagte erste (1) und zweite (2) Oberflächenschicht einander gegenüberliegend angeordnet sind und durch eine Elastomerschicht (3) voneinander getrennt sind.

13. Elektrode gemäß Anspruch 8, weiterhin umfassend eine auf der elektrisch leitfähige Kohlenstoffteilchen umfassenden Oberflächenschicht (1) angeordneten zusätzlichen elektrisch leitfähigen Schicht (4), wobei die zusätzliche elektrisch leitfähige Schicht (4) bei einer Dehnung der Oberflächenschicht (1) vor dieser aufbricht oder reißt.

14. Elektrode gemäß Anspruch 13, wobei die zusätzliche elektrisch leitfähige Schicht (4) Gold, Silber, Kupfer, Indium-Zinn-Oxid, Fluordotiertes Zinn(IV)-Oxid, Aluminiumdotiertes Zinkoxid, Antimondotiertes Zinn(IV)-Oxid und/oder Poly-(3,4-Ethylendioxythiophen) umfasst.

15. Verwendung einer Elektrode gemäß Anspruch 8 als elektromechanischer Wandler, als elektromechanischer Aktor und/oder als elektromechanischer Sensor.
